(19) Europäisches Patentamt
European Patent Office
Office européen des brevets

(11) **EP 4 755 554 A1**

(12) **EUROPEAN PATENT APPLICATION**
published in accordance with Art. 153(4) EPC

(43) Date of publication:
**10.06.2026 Bulletin 2026/24**

(21) Application number: **24941725.4**

(22) Date of filing: **29.05.2024**

(51) International Patent Classification (IPC):
**B23B 27/14** *(2006.01)*     **C23C 16/40** *(2006.01)*

(52) Cooperative Patent Classification (CPC):
**B23B 27/14; C23C 16/40**

(86) International application number:
**PCT/JP2024/019734**

(87) International publication number:
**WO 2025/248668 (04.12.2025 Gazette 2025/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Sumitomo Electric Hardmetal Corp.
Itami-shi, Hyogo 664-0016 (JP)**

(72) Inventors:
• **HIKIJI, Masahito**
  **Itami-shi, Hyogo 664-0016 (JP)**
• **YONEDA, Atsuhiro**
  **Itami-shi, Hyogo 664-0016 (JP)**
• **YAMANISHI, Takato**
  **Itami-shi, Hyogo 664-0016 (JP)**

(74) Representative: **Boult Wade Tennant LLP
Salisbury Square House
8 Salisbury Square
London EC4Y 8AP (GB)**

(54) **CUTTING TOOL**

(57)     A cutting tool includes a base material and a coating provided on the base material, the coating includes an $\alpha$-Al$_2$O$_3$ layer, the $\alpha$-Al$_2$O$_3$ layer has a thickness of 3 $\mu$m or more and 20 $\mu$m or less, and, in a measurement field in a rectangular shape that is provided in a cross section of the coating along a normal line to a surface of the coating, and has a dimension of 30 $\mu$m in a first direction along the surface of the coating, and a dimension in a second direction orthogonal to the first direction of the coating, including an entire thickness of the $\alpha$-Al$_2$O$_3$ layer along the second direction, the number of first $\Sigma$3 grain boundaries continuous from an imaginary line L1 to an imaginary line L2 and intersecting an imaginary line L3 is 5 or more, where the imaginary line L1 is an imaginary line at a distance of 0.5 $\mu$m toward the $\alpha$-Al$_2$O$_3$ layer, from a first interface of the $\alpha$-Al$_2$O$_3$ layer, the first interface being an interface located toward the base material, the imaginary line L2 is an imaginary line at a distance of 0.5 $\mu$m toward the $\alpha$-Al$_2$O$_3$ layer, from a second interface of the $\alpha$-Al$_2$O$_3$ layer, the second interface being an interface located toward the surface of the coating, and the imaginary line L3 is an imaginary line located equidistantly from the imaginary line L 1 and the imaginary line L2.

FIG.1

**Description**

TECHNICAL FIELD

The present disclosure relates to a cutting tool.

BACKGROUND ART

Cutting tools having a coating formed on a base material have been conventionally used. Aluminum oxide having an $\alpha$-type crystal structure (hereinafter also referred to as "$\alpha$-Al$_2$O$_3$") has been used as a coating material, due to its excellent mechanical properties (PTL 1 and PTL 2).

CITATION LIST

PATENT LITERATURE

PTL 1: Japanese Patent Laying-Open No. 2002-131058
PTL 2: Japanese Patent Laying-Open No. 2023-101044

SUMMARY OF INVENTION

A cutting tool of the present disclosure is a cutting tool that includes a base material and a coating provided on the base material, the coating includes an $\alpha$-Al$_2$O$_3$ layer, the $\alpha$-Al$_2$O$_3$ layer has a thickness of 3 $\mu$m or more and 20 $\mu$m or less, and, in a measurement field in a rectangular shape that is provided in a cross section of the coating along a normal line to a surface of the coating, and has a dimension of 30 $\mu$m in a first direction along the surface of the coating, and a dimension in a second direction orthogonal to the first direction of the coating, including an entire thickness of the $\alpha$-Al$_2$O$_3$ layer along the second direction, the number of first $\Sigma$3 grain boundaries continuous from an imaginary line L1 to an imaginary line L2 and intersecting an imaginary line L3 is 5 or more, where the imaginary line L1 is an imaginary line at a distance of 0.5 $\mu$m toward the $\alpha$-Al$_2$O$_3$ layer, from a first interface of the $\alpha$-Al$_2$O$_3$ layer, the first interface being an interface located toward the base material, the imaginary line L2 is an imaginary line at a distance of 0.5 $\mu$m toward the $\alpha$-Al$_2$O$_3$ layer, from a second interface of the $\alpha$-Al$_2$O$_3$ layer, the second interface being an interface located toward the surface of the coating, and the imaginary line L3 is an imaginary line located equidistantly from the imaginary line L1 and the imaginary line L2.

BRIEF DESCRIPTION OF DRAWINGS

[Fig. 1] Fig. 1 is a schematic diagram showing an example of a cross section of a cutting tool according to Embodiment 1.
[Fig. 2] Fig. 2 is a diagram illustrating a method of measuring the number of first $\Sigma$3 grain boundaries.
[Fig. 3] Fig. 3 is an enlarged view of a region in the vicinity of an interface between an $\alpha$-Al$_2$O$_3$ layer and a first layer in a cross section of a coating.

DETAILED DESCRIPTION

[Problem to be Solved by the Present Disclosure]

In the case of the techniques of PTL 1 and PTL 2, there is a tendency that crater wear accompanied by loss of $\alpha$-Al$_2$O$_3$ particles occur as the cutting tool is used, resulting in a shortened tool life.
In view of the above, an object of the present disclosure is to provide a cutting tool that has a coating including an $\alpha$-Al$_2$O$_3$ layer, with a long tool life.

[Advantageous Effect of the Present Disclosure]

According to the present disclosure, a cutting tool having a coating including an $\alpha$-Al$_2$O$_3$ layer, with a long tool life can be provided.

[Description of Embodiments]

Initially, aspects of the present disclosure are described one by one.

(1) A cutting tool of the present disclosure is a cutting tool that includes a base material and a coating provided on the base material, the coating includes an $\alpha$-$Al_2O_3$ layer, the $\alpha$-$Al_2O_3$ layer has a thickness of 3 $\mu$m or more and 20 $\mu$m or less, and, in a measurement field in a rectangular shape that is provided in a cross section of the coating along a normal line to a surface of the coating, and has a dimension of 30 $\mu$m in a first direction along the surface of the coating, and a dimension in a second direction orthogonal to the first direction of the coating, including an entire thickness of the $\alpha$-$Al_2O_3$ layer along the second direction, the number of first $\Sigma3$ grain boundaries continuous from an imaginary line L1 to an imaginary line L2 and intersecting an imaginary line L3 is 5 or more, where the imaginary line L1 is an imaginary line at a distance of 0.5 $\mu$m toward the $\alpha$-$Al_2O_3$ layer, from a first interface of the $\alpha$-$Al_2O_3$ layer, the first interface being an interface located toward the base material, the imaginary line L2 is an imaginary line at a distance of 0.5 $\mu$m toward the $\alpha$-$Al_2O_3$ layer, from a second interface of the $\alpha$-$Al_2O_3$ layer, the second interface being an interface located toward the surface of the coating, and the imaginary line L3 is an imaginary line located equidistantly from the imaginary line L1 and the imaginary line L2.

According to the present disclosure, a cutting tool can be provided that has a coating including an $\alpha$-$Al_2O_3$ layer, with a long tool life.

(2) According to the above (1), the number of the first $\Sigma3$ grain boundaries may be 100 or less. Accordingly, loss of $\alpha$-$Al_2O_3$ particles during use of the cutting tool, which is caused by excessive miniaturization of the $\alpha$-$Al_2O_3$ particles, is suppressed, and the wear resistance of the $\alpha$-$Al_2O_3$ layer is improved.

(3) According to the above (1) or (2), in the measurement field, the number of all grain boundaries intersecting the imaginary line L3 may be 20 or more. Accordingly, there is no increase in the particle size of $\alpha$-$Al_2O_3$ particles, and the wear resistance of the $\alpha$-$Al_2O_3$ layer is improved.

(4) According to any one of the above (1) to (3), the $\alpha$-$Al_2O_3$ layer may have a TC(0 0 12) of 5 or more in an orientation index TC(hkl). Accordingly, the wear resistance of the $\alpha$-$Al_2O_3$ layer is improved.

(5) According to any one of the above (1) to (4), the coating may further include a first layer disposed between the base material and the $\alpha$-$Al_2O_3$ layer, and the first layer may be a TiCN layer. Accordingly, the wear resistance and the breakage resistance of the coating are improved.

(6) According to any one of the above (1) to (5), the coating may further include a second layer disposed on a main surface of the $\alpha$-$Al_2O_3$ layer opposite to a main surface of the $\alpha$-$Al_2O_3$ layer located relatively closer to the base material, and the second layer may include at least one selected from the group consisting of TiN layer, TiCN layer, and TiCNO layer. When the second layer is at least one of the TiN layer and the TiCN layer, it is easy to identify the corner of the cutting insert after being used for cutting (identify the used area). When the second layer includes the TiCNO layer, the adhesion between the $\alpha$-$Al_2O_3$ layer and the second layer is improved and thereby growth of wear at the initial stage of cutting can be suppressed, by disposing a TiCN layer directly on the $\alpha$-$Al_2O_3$ layer and disposing a TiN layer or a TiCN layer directly on the TiCN layer.

[Details of Embodiments]

Specific examples of the cutting tool of the present disclosure are described below with reference to the drawings. In the drawings of the present disclosure, the same reference signs denote the same parts or equivalent parts. The dimensional relationships among length, width, thickness, depth and the like are changed as appropriate for the purpose of clarifying and simplifying the drawings, and do not necessarily represent the actual dimensional relationships.

The expression in the form of "A to B" in the present disclosure means A or more and B or less and, if A is not accompanied by an indication of a unit and only B is accompanied by an indication of a unit, the unit for A is the same as that for B.

In the present disclosure, in the case where a compound or the like is represented by a chemical formula, the atomic ratio is intended to include any conventionally known atomic ratio if the atomic ratio is not particularly limited, and the atomic ratio should not necessarily be limited to those in a stoichiometric range.

In the present disclosure, in the case where one or more numerical values are specified as each of the lower limit and the upper limit of a numerical range, it is intended that a combination of any one numerical value specified as the lower limit and any one numerical value specified as the upper limit is also disclosed.

In the present disclosure, "comprise", "include" and "have" as well as their variations are open-ended terms. The open-ended term may or may not further include an additional element(s), in addition to an essential element(s). The wording "consist of" is a closed term. It should be noted that a feature expressed by a closed term may still include an additional element(s) such as impurities that are usually included or an element(s) irrelevant to the intended technique.

For further understanding of the present disclosure, a configuration of the $\alpha$-$Al_2O_3$ layer is described first. A "grain boundary" is present between $\alpha$-$Al_2O_3$ particles included in the $\alpha$-$Al_2O_3$ layer.

Grain boundaries in the $\alpha$-$Al_2O_3$ layer include CSL grain boundaries and general grain boundaries. CSL grain boundaries include $\Sigma3$ grain boundary, $\Sigma7$ grain boundary, $\Sigma11$ grain boundary, $\Sigma17$ grain boundary, $\Sigma19$ grain boundary, $\Sigma21$ grain boundary, $\Sigma23$ grain boundary, and $\Sigma29$ grain boundary.

The $\Sigma3$ grain boundary has the lowest grain boundary energy among the CSL grain boundaries of $\alpha$-$Al_2O_3$. Therefore, as the ratio of the $\Sigma3$ grain boundary to all the grain boundaries in the $\alpha$-$Al_2O_3$ layer is higher, the mechanical properties including the plastic deformation resistance of the $\alpha$-$Al_2O_3$ layer are improved.

Both PTL 1 and PTL 2 intend to improve the tool life by controlling the amount of $\Sigma3$ grain boundaries in the $\alpha$-$Al_2O_3$ layer. However, the present inventors cut chromium molybdenum steel with the cutting tools described in PTL 1 and PTL 2 to found that crater wear accompanied by loss of $\alpha$-$Al_2O_3$ particles occurred, resulting in shortening of the tool life. The present inventors investigated reasons for this, and obtained the following findings.

In PTL 1, while the ratio of $\Sigma3$ grain boundaries is higher in a lower portion of the $\alpha$-$Al_2O_3$ layer close to the base material, the ratio of $\Sigma3$ grain boundaries is lower in an upper portion of the $\alpha$-$Al_2O_3$ layer. Therefore, in the upper portion, it is more likely that $\alpha$-$Al_2O_3$ particles are lost and crater wear occurs.

In PTL 2, the $\alpha$-$Al_2O_3$ layer is formed through a first step and a second step. Therefore, a $\Sigma3$ grain boundary in a region formed in the first step and a $\Sigma3$ grain boundary in a region formed in the second step are not continuous with each other and, if cracks grow in the $\alpha$-$Al_2O_3$ layer, it is more likely that $\alpha$-$Al_2O_3$ particles are lost and crater wear occurs.

Having conducted studies thoroughly based on the findings as set forth above, the present inventors have found that the tool life of the cutting tool can be improved by controlling the amount of $\Sigma3$ grain boundaries in the $\alpha$-$Al_2O_3$ layer and controlling the form in which $\Sigma3$ grain boundaries are present. The following is a description of a cutting tool according to the present disclosure.

[Embodiment 1: Cutting Tool]

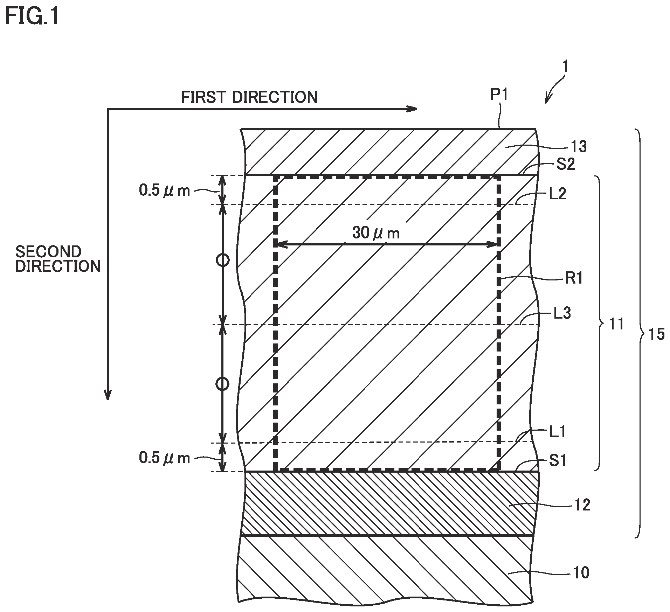

A cutting tool according to one embodiment of the present disclosure (hereinafter also referred to as "the present embodiment") is described with reference to Fig. 1. The cutting tool of the present embodiment includes a base material 10 and a coating 15 provided on base material 10. Coating 15 includes an $\alpha$-$Al_2O_3$ layer 11. $\alpha$-$Al_2O_3$ layer 11 has a thickness of 3 $\mu$m or more and 20 $\mu$m or less. In a measurement field R1 in a rectangular shape that is provided in a cross section of coating 15 along a normal line to a surface P1 of coating 15, and has a dimension of 30 $\mu$m in a first direction along surface P1 of coating 15, and a dimension in a second direction orthogonal to the first direction of coating 15, including an entire thickness of $\alpha$-$Al_2O_3$ layer 11 along the second direction, the number of first $\Sigma3$ grain boundaries continuous from an imaginary line L1 to an imaginary line L2 and intersecting an imaginary line L3 is 5 or more. Imaginary line L1 is an imaginary line at a distance of 0.5 $\mu$m toward $\alpha$-$Al_2O_3$ layer 11, from a first interface S1 of $\alpha$-$Al_2O_3$ layer 11, the first interface being an interface located toward base material 10. Imaginary line L2 is an imaginary line at a distance of 0.5 $\mu$m toward $\alpha$-$Al_2O_3$ layer 11, from a second interface S2 of $\alpha$-$Al_2O_3$ layer 11, the second interface being an interface located toward surface P1 of coating 15. Imaginary line L3 is an imaginary line located equidistantly from imaginary line L1 and imaginary line L2.

In Fig. 1, since a first layer 12 is provided directly beneath $\alpha$-$Al_2O_3$ layer 11, the interface between $\alpha$-$Al_2O_3$ layer 11 and first layer 12 corresponds to first interface S1. When first layer 12 is not provided directly beneath $\alpha$-$Al_2O_3$ layer 11 and $\alpha$-$Al_2O_3$ layer 11 is provided directly on base material 10, the interface between $\alpha$-$Al_2O_3$ layer 11 and base material 10 corresponds to first interface S1. When first layer 12 is not provided directly beneath $\alpha$-$Al_2O_3$ layer 11 and $\alpha$-$Al_2O_3$ layer 11 is provided directly on another layer such as an intermediate layer, the interface between $\alpha$-$Al_2O_3$ layer 11 and the other layer corresponds to first interface S1.

In Fig. 1, since a second layer 13 is provided directly on $\alpha$-$Al_2O_3$ layer 11, the interface between $\alpha$-$Al_2O_3$ layer 11 and second layer 13 corresponds to second interface S2. When second layer 13 is not provided directly on $\alpha$-$Al_2O_3$ layer 11 and $\alpha$-$Al_2O_3$ layer 11 is the outermost surface layer of the coating, the surface of $\alpha$-$Al_2O_3$ layer 11 corresponds to second interface S2.

The cutting tool of the present disclosure that has the coating including the $\alpha$-$Al_2O_3$ layer can have a long tool life. The reason for this is inferred as follows. As for the cutting tool of the present disclosure, in measurement field R1, the number of first $\Sigma3$ grain boundaries continuous from imaginary line L1 to imaginary line L2 and intersecting imaginary line L3 is 5 or more. The first $\Sigma3$ grain boundary is an index indicating the amount of $\Sigma3$ grain boundaries continuous from a region of the $\alpha$-$Al_2O_3$ layer that is close to the base material, to a region thereof that is close to the surface of the coating, among $\Sigma3$ grain boundaries in the $\alpha$-$Al_2O_3$ layer. When there is a large amount of first $\Sigma3$ grain boundaries in the $\alpha$-$Al_2O_3$ layer, $\alpha$-$Al_2O_3$ particles are less likely to be lost during use of the cutting tool, and crater wear is suppressed. Accordingly, the tool life of the cutting tool of the present disclosure is improved.

<Configuration of Cutting Tool>

As shown in Fig. 1, a cutting tool 1 of the present embodiment includes base material 10 and coating 15 provided on base material 10. Coating 15 includes $\alpha$-$Al_2O_3$ layer 11. Coating 15 may cover at least a part of a portion, involved in cutting, of the base material, or may cover the entire surface of the base material. The portion, involved in cutting, of the base material means a region, on the surface of the base material, within a distance of 1.5 mm from the ridgeline of the cutting edge. The fact that a part of the base material is not covered with this coating or the configuration of the coating is partially different does not depart from the scope of the present disclosure.

<Applications of Cutting Tool>

Examples of the cutting tool of the present disclosure can include drill, end mill, indexable cutting insert for the drill, indexable cutting insert for the end mill, indexable cutting insert for milling, indexable cutting insert for turning, metal saw, gear cutting tool, reamer, and tap.

<Base Material>

The base material includes a rake face and a flank face, and any conventionally known base material of this type may be used. For example, the material for the base material may be cemented carbide (for example, WC-based cemented carbide such as WC-Co-based cemented carbide, where the cemented carbide can contain a carbonitride of Ti, Ta, Nb or the like), cermet (containing TiC, TiN, TiCN or the like as a main component), high-speed steel, ceramic (such as titanium carbide, silicon carbide, silicon nitride, aluminum nitride, and aluminum oxide), cubic boron nitride sintered material, or diamond sintered material.

The material for the base material may be cemented carbide (particularly WC-based cemented carbide) or cermet (particularly TiCN-based cermet). A base material made of a cemented carbide or a cermet has an excellent balance between hardness and strength at a high temperature, and has excellent properties as a base material of a cutting tool for the above applications. When a WC-based cemented carbide is used as a base material, it may contain a free carbon and an abnormal layer such as that called $\eta$ phase or $\epsilon$ phase in its structure.

The surface of the base material may be modified. For example, in the case of the cemented carbide, it may have a $\beta$-free layer formed on the surface thereof, and in the case of the cermet, it may have a hardened layer formed on the surface. The base material exhibits desired effects even if its surface is modified.

When the cutting tool is an indexable cutting insert or the like, the base material may or may not have a tip breaker. The ridgeline of the cutting edge may have any of those shapes such as a sharp edge shape (a ridge where the rake face and the flank face meet each other), a honed shape (a rounded sharp edge), a negative land shape (chamfered), or a combination of a honed shape and a negative land shape.

<Coating>

<<Configuration of Coating>>

The coating includes the $\alpha$-$Al_2O_3$ layer provided on the base material. Coating 15 may be formed by the $\alpha$-$Al_2O_3$ layer. In this case, the $\alpha$-$Al_2O_3$ layer is provided directly on the base material, and a main surface of the $\alpha$-$Al_2O_3$ layer opposite to a main surface thereof that is located relatively closer to the base material corresponds to the outermost surface of the coating.

As shown in Fig. 1, coating 15 may further include first layer 12 disposed between base material 10 and $\alpha$-$Al_2O_3$ layer 11.

As shown in Fig. 1, coating 15 may further include second layer 13 disposed on the main surface of $\alpha$-$Al_2O_3$ layer 11 opposite to the main surface thereof located relatively closer to base material 10.

As shown in Fig. 1, coating 15 may include an intermediate layer (not shown) provided between the first layer and the $\alpha$-$Al_2O_3$ layer.

<<Thickness of Entire Coating>>

The thickness of the entire coating may be 5 $\mu$m or more and 30 $\mu$m or less, 7 $\mu$m or more and 20 $\mu$m or less, or 10 $\mu$m or more and 15 $\mu$m or less. When the average thickness of the entire coating is 5 $\mu$m or more, the wear resistance of the coating is improved. When the average thickness of the entire coating is 30 $\mu$m or less, the peeling resistance of the coating is improved.

The thickness of the entire coating is measured by obtaining a cross-sectional sample parallel to the normal direction to the surface of the base material and observing this sample with a scanning transmission electron microscope (STEM). Examples of the scanning transmission electron microscope include JEM-2100F (trade name) manufactured by JEOL Ltd.

In the present disclosure, "thickness" means average thickness. A specific measurement method is as follows. The cutting tool is cut along a cross section parallel to the normal direction to the surface to obtain a sample having the coating whose cross section is exposed. The sample is observed with a scanning transmission electron microscope (STEM). The observation magnification is set to 5000 times. In a STEM image, a measurement field in a rectangular shape of (30 $\mu$m in the direction parallel to the surface of the base material) $\times$ (distance including the entire thickness of the coating) is set, the thickness size is measured at 10 sites in the measurement field, and the average value thereof is defined as "thickness". The thickness of each layer described later herein is also measured in the same manner.

<$\alpha$-Al$_2$O$_3$ Layer>

<<Thickness of $\alpha$-Al$_2$O$_3$ Layer>>

The thickness of the $\alpha$-Al$_2$O$_3$ layer may be 3 $\mu$m or more and 20 $\mu$m or less, 5 $\mu$m or more and 15 $\mu$m or less, or 7 $\mu$m or more and 12 $\mu$m or less.

<<Configuration of $\alpha$-Al$_2$O$_3$ Layer>>

In the present embodiment, the $\alpha$-Al$_2$O$_3$ layer includes a plurality of $\alpha$-Al$_2$O$_3$ (aluminum oxide having the $\alpha$-type crystal structure) particles. The $\alpha$-Al$_2$O$_3$ layer may be made up of a plurality of $\alpha$-Al$_2$O$_3$ particles. The $\alpha$-Al$_2$O$_3$ layer may include unavoidable impurities as long as the advantageous effects of the present embodiment are not impaired. Examples of the unavoidable impurities include chlorine (Cl). The content of the unavoidable impurities in the $\alpha$-Al$_2$O$_3$ layer may be 3% by mass or less. The content of the unavoidable impurities in the $\alpha$-Al$_2$O$_3$ layer is measured by secondary ion mass spectrometry (SIMS).

Grain boundaries in the $\alpha$-Al$_2$O$_3$ layer of the present embodiment include CSL grain boundaries and general grain boundaries. CSL grain boundaries include $\Sigma$3 grain boundary, $\Sigma$7 grain boundary, $\Sigma$11 grain boundary, $\Sigma$17 grain boundary, $\Sigma$19 grain boundary, $\Sigma$21 grain boundary, $\Sigma$23 grain boundary, and $\Sigma$29 grain boundary. As long as the advantageous effects of the present disclosure are not impaired, the fact that any one or more grain boundaries other than the $\Sigma$3 grain boundary are not observed does not depart from the scope of the present disclosure.

<<$\Sigma$3 Grain Boundary>>

In the $\alpha$-Al$_2$O$_3$ layer of the present embodiment, the number of first $\Sigma$3 grain boundaries in measurement field R1 is 5 or more. The number of first $\Sigma$3 grain boundaries in measurement field R1 may be 5 or more and 100 or less, 10 or more and 75 or less, or 20 or more and 50 or less, from the viewpoint of improving the crater wear resistance.

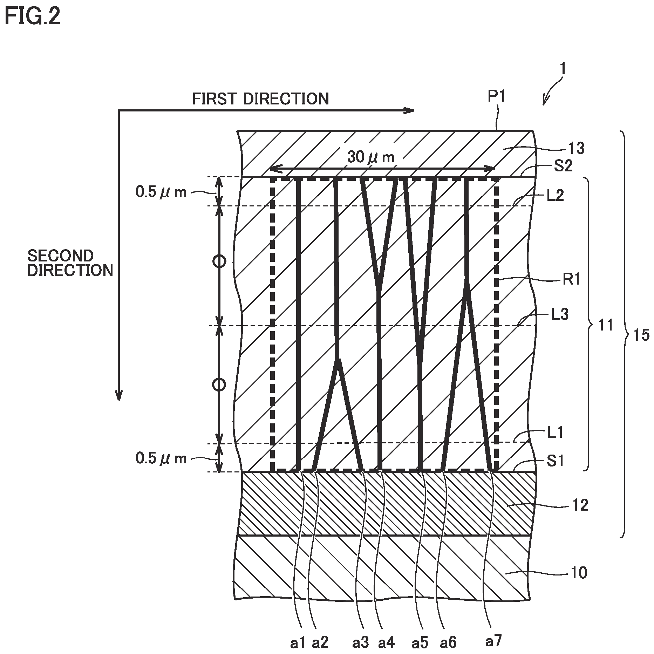

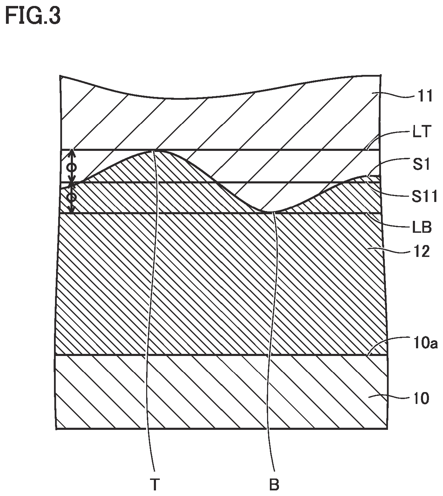

A method of measuring the number of first $\Sigma$3 grain boundaries in measurement field R1 is described with reference to Figs. 2 and 3. Fig. 2 is a diagram illustrating a method of measuring the number of first $\Sigma$3 grain boundaries. Fig. 2 schematically shows an example of a cross section of the coating. Fig. 3 is a diagram illustrating a method of setting a first interface. Fig. 3 shows an enlarged view of a region in the vicinity of the interface between the $\alpha$-Al$_2$O$_3$ layer and the first layer in a cross section of the coating.

(A1) The cutting tool is cut with a diamond wire along a normal line to the rake face of the base material to expose a cross section of the $\alpha$-Al$_2$O$_3$ layer. The position where the tool is cut is set at a position in which the surface of the cutting tool is smooth and which includes the cutting edge of the cutting tool. The exposed cross section is subjected to ion milling with Ar ions so that the cross section becomes a mirror surface state. Conditions for the ion milling are as follows. The acceleration voltage is 6 kV. The irradiation angle is 0° from the linear direction parallel to the thickness direction of the $\alpha$-Al$_2$O$_3$ layer in the cross section of the $\alpha$-Al$_2$O$_3$ layer. The irradiation time is 6 hours.

(A2) The cross section in the mirror surface state is observed with a field-emission scanning electron microscope (EF-SEM) at a magnification of 5000 times to obtain a backscattered electron image (EBSD). Conditions for the SEM are as follows. A normal line to the cross section is inclined by 70° with respect to an incident beam. Analysis is conducted at 15 kV. In order to avoid the electrostatic charging effect, a pressure of 10 Pa is applied. A high current mode is used in combination with an aperture diameter of 60 $\mu$m or 120 $\mu$m. The step is set to 0.1 $\mu$m/step.

(A3) The EBSD image is subjected to data processing to obtain a first image in which $\Sigma$3 grain boundaries are displayed in the EBSD image so as to be distinguished from other grain boundaries. Data is processed with and without noise filtering. The noise filtering and grain boundary character distribution are determined by using commercially available software (trade name: "orientation Imaging microscopy Ver 6.2", manufactured by EDAX Inc.). The grain boundary character distribution is analyzed based on data available from Grimmer (H. Grimmer, R. Bonnet, Philosophical Magazine A 61 (1990), 493-509). With Brandon criterion ($\Delta\Theta < \Theta_0$ ($\Sigma$)-0.5, where $\Theta_0 = 15°$), a tolerance of an experimental value from a theoretical value is taken into account (D. Brandon Acta metall. 14 (1966), 1479-1484).

(A4) In the first image, measurement field R1 in a rectangular shape is set that has a dimension of 30 $\mu$m in the first direction along surface P1 of coating 15, and a dimension in the second direction orthogonal to the first direction of coating 15, including the entire thickness of $\alpha$-$Al_2O_3$ layer 11 along the second direction.

(AS) In the first image, imaginary line L1 is set at a distance of 0.5 $\mu$m toward $\alpha$-$Al_2O_3$ layer 11, from first interface S1 of $\alpha$-$Al_2O_3$ layer 11, where the first interface is located toward base material 10, imaginary line L2 is set at a distance of 0.5 $\mu$m toward the $\alpha$-$Al_2O_3$ layer, from second interface S2 of the $\alpha$-$Al_2O_3$ layer, where the second interface is located toward surface P1 of coating 15, and imaginary line L3 is set that is located equidistantly from imaginary line L1 and imaginary line L2.

In the case where actual first interface S1 is uneven, as shown in Fig. 3, a straight line S11 is regarded as first interface S1, where straight line S11 is located equidistantly from an imaginary line LB and an imaginary line LT, imaginary line LB passes through a bottom B of first interface S1 and is parallel to a main surface 10a of base material 10, and imaginary line LT passes through a top T of first interface S1 and is parallel to main surface 10a of base material 10. In the case where actual second interface S2 is uneven as well, a straight line located equidistantly from an imaginary line passing through the bottom of second interface S2 and parallel to the main surface of the base material and an imaginary line passing through the top thereof and parallel to the main surface of the base material is regarded as the second interface.

(A6) In measurement field R1, the number of first $\Sigma$3 grain boundaries continuous from imaginary line L1 to imaginary line L2 and intersecting imaginary line L3 is measured. In measurement field R1 shown in Fig. 2, seven first $\Sigma$3 grain boundaries are observed. A specific method of counting the grain boundaries is described with reference to Fig. 3. In Fig. 3, thick lines in measurement field R1 represent $\Sigma$3 grain boundaries.

A $\Sigma$3 grain boundary a1 is a single line continuous from imaginary line L1 to imaginary line L2 and intersecting imaginary line L3. In this case, the number of first $\Sigma$3 grain boundaries intersecting imaginary line L3 is one.

A $\Sigma$3 grain boundary a2 and a $\Sigma$3 grain boundary a3 merge at a position closer to the base material than imaginary line L3 is to the base material, to form a single $\Sigma$3 grain boundary, and this single grain boundary intersects imaginary line L3. In this case, the number of first $\Sigma$3 grain boundaries intersecting imaginary line L3 is one.

A $\Sigma$3 grain boundary a4 branches at a position closer to the surface of the coating than imaginary line L3 is to the surface thereof, into two $\Sigma$3 grain boundaries, and each of the two $\Sigma$3 grain boundaries is continuous to imaginary line L2. In this case, the number of first $\Sigma$3 grain boundaries intersecting imaginary line L3 is one.

A $\Sigma$3 grain boundary as branches at a position closer to the base material than imaginary line L3 is to the base material, into two $\Sigma$3 grain boundaries, and each of the two $\Sigma$3 grain boundaries is continuous to imaginary line L2. In this case, the number of first $\Sigma$3 grain boundaries intersecting imaginary line L3 is two.

A $\Sigma$3 grain boundary a6 and a $\Sigma$3 grain boundary a7 merge at a position closer to the surface of the coating, than imaginary line L3 is to the surface thereof, to form a single $\Sigma$3 grain boundary, and this single grain boundary intersects imaginary line L3. In this case, the number of first $\Sigma$3 grain boundaries intersecting imaginary line L3 is two.

(A7) The number of first $\Sigma$3 grain boundaries is measured in three measurement fields R1 that do not overlap each other. The average of respective numbers of the first $\Sigma$3 grain boundaries in the three measurement fields R1 is calculated. In the present disclosure, the average corresponds to the number of first $\Sigma$3 grain boundaries in the measurement field.

It was confirmed that the same results were obtained even when the above-described measurement was performed by arbitrarily setting a plurality of measurement fields in the same specimen.

In the measurement field provided in the $\alpha$-$Al_2O_3$ layer of the present embodiment, the number of all grain boundaries intersecting imaginary line L3 may be 20 or more, may be 20 or more and 150 or less, may be 40 or more and 150 or less, or may be 50 or more and 100 or less.

A method of measuring the number of all grain boundaries intersecting imaginary line L3 in the measurement field is described below. An EBSD image is obtained by the same method as (A1) and (A2) of the method of measuring the number of first $\Sigma$3 grain boundaries in measurement field R1. Data processing is performed on the EBSD image to obtain a second image in which all grain boundaries are shown in an SEM image. Measurement field R1 and imaginary line L3 are set in the second image by the same method as (A4) and (AS) above. In measurement field R1, the number of all grain boundaries intersecting imaginary line L3 is measured. The measurement is performed in three measurement fields R1 that do not overlap each other. The average of respective numbers of grain boundaries of the three measurement fields R1 is calculated. In the present disclosure, the average corresponds to the number of all grain boundaries intersecting imaginary line L3 in the measurement field.

It was confirmed that the same results were obtained even when the above-described measurement was performed by arbitrarily setting a plurality of measurement fields in the same specimen.

<<Orientation Index>>

The $\alpha$-Al$_2$O$_3$ layer of the present embodiment may have a TC(0 0 12) in an orientation index TC(hkl) of 5 or more, 5 or more and 8 or less, or 7 or more and 8 or less. The orientation index TC(hkl) is represented by the following expression (1).
[Expression 1]

$$TC(hkl) = \frac{I(hkl)}{I_0(hkl)} \left\{ \frac{1}{n} \sum_{1}^{n} \frac{I(hkl)}{I_0(hkl)} \right\}^{-1} \qquad \dots (1)$$

In the expression (1), I(hkl) represents the X-ray diffraction intensity on the reflection plane (hkl), and I$_0$(hkl) represents the standard intensity according to the PDF card No. 00-010-0173 of ICDD. In the expression (1), n represents the number of reflections used in the calculation and is 8 in the present embodiment. The planes (hkl) used for reflection are (012), (104), (110), (0 0 12), (113), (024), (116) and (300).

ICDD (registered trademark) is an abbreviation for International Centre for Diffraction Data. PDF (registered trademark) is an abbreviation for Powder Diffraction File.

The TC(hkl) measurement as described above can be performed by analysis with an X-ray diffractometer. TC(hkl) can be measured, for example, using SmartLb/a (registered trademark) (scan speed: 21.7°/min; step: 0.01°; scan range: 15 to 140°) manufactured by Rigaku Corporation under the following conditions. In the present embodiment, the measurement results of TC(hkl) with the X-ray diffractometer are referred to as "XRD results".

Characteristic X-ray: Cu-K$\alpha$

    Tube voltage: 45 kV
    Tube current: 200 mA
    Filter: multi-layer mirror
    Optical system: concentration method
    X-Ray diffraction method: $\theta$-2$\theta$ method

When using the X-ray diffractometer, the flank face of the cutting tool is irradiated with X-rays. Usually, the rake face is uneven while the flank face is flat. Therefore, it is preferable to irradiate the flank face with X-rays in order to eliminate disturbance factors. The flank face is irradiated with X-rays particularly on an area that extends in a range of about 2 to 4 mm from a ridgeline of a cutting edge. This results in a high reproducibility. In the present embodiment, the values of TC(hkl) of the $\alpha$-Al$_2$O$_3$ layer on the flank face of the base material are the same as the values of TC(hkl) of the $\alpha$-Al$_2$O$_3$ layer on the rake face of the base material.

It was confirmed that the same results were obtained even when the above-described measurement was performed by arbitrarily setting a plurality of measurement fields in the same specimen.

<First Layer>

Coating 15 of the present embodiment may further include first layer 12 disposed between base material 10 and $\alpha$-Al$_2$O$_3$ layer 11. The first layer corresponds to an underlayer. First layer 12 may be provided directly on base material 10. $\alpha$-Al$_2$O$_3$ layer 11 may be provided directly on first layer 12. First layer 12 may be a TiCN layer or a TiN layer, or may be a TiCN layer.

The average thickness of the first layer may be 0.1 $\mu$m or more and 20 $\mu$m or less. Accordingly, the wear resistance and the breakage resistance of the coating are further improved.

<Second Layer>

Coating 15 of the present embodiment may further include second layer 13 disposed on the main surface of $\alpha$-Al$_2$O$_3$ layer 11 opposite to the main surface thereof located relatively closer to base material 10. The second layer corresponds to a surface layer. The main surface of the second layer opposite to the main surface thereof relatively closer to the base material corresponds to the outermost surface of the coating. The second layer may be a TiN layer, a TiCN layer, or a TiCNO layer.

The average thickness of the second layer may be 0.05 $\mu$m or more and 1 $\mu$m or less. Accordingly, the adhesion between the second layer and its adjacent layer is improved.

<Intermediate Layer>

Coating 15 may include an intermediate layer (not shown) provided between the first layer and the $\alpha$-Al$_2$O$_3$ layer. The intermediate layer may be in contact with the first layer and the $\alpha$-Al$_2$O$_3$ layer. The intermediate layer may be a TiCN layer or a TiCNO layer. Since the TiCN layer and the TiCNO layer are excellent in the wear resistance, it is possible to impart more suitable wear resistance to the coating. The average thickness of the intermediate layer may be 1 $\mu$m or more and 20 $\mu$m or less.

<Method of Manufacturing Cutting Tool>

The cutting tool of the present embodiment can be manufactured by forming the coating on the base material with the chemical vapor deposition (CVD) method. In the coating, the $\alpha$-Al$_2$O$_3$ layer can be formed, for example, by the following method. The layers other than the $\alpha$-Al$_2$O$_3$ layer in the coating can be formed under conventionally known conditions.
The step of forming the $\alpha$-Al$_2$O$_3$ layer includes a first step and a second step. The conditions throughout the whole step of forming the $\alpha$-Al$_2$O$_3$ layer are: a temperature of 1000°C and a pressure of 70 hPa. The gas flow rate (total gas flow rate) in the first step is set to 70 to 90 L/min, and the gas flow rate (total gas flow rate) in the second step is set to 100 to 130 L/min.
AlCl$_3$, HCl, CO$_2$, CO, H$_2$S and H$_2$ are used as raw material gases. Respective proportions of the raw material gases are changed depending on the thickness of the formed $\alpha$-Al$_2$O$_3$ layer, from the start of formation of the layer. Specifically, they are as follows.
The first step is a step of forming a region, from the start of formation to formation of the $\alpha$-Al$_2$O$_3$ layer of 1.5 $\mu$m in thickness. In the first step, respective proportions of the raw material gases are: AlCl$_3$: 1.3 to 1.7% by volume, HCl: 1.8 to 2.2% by volume, CO$_2$: 1.3 to 1.7% by volume, CO: 2.2 to 2.8% by volume, and H$_2$: the balance in % by volume, based on the total of the raw material gases of 100% by volume. The proportion of 2.2 to 2.8% by volume of CO in the raw material gases is larger than the proportion (for example, 0 to 1% by volume) of CO in the raw material gases used for forming a conventional $\alpha$-Al$_2$O$_3$ layer.
The second step is a step of forming a region of the $\alpha$-Al$_2$O$_3$ layer of more than 1.5 $\mu$m and less than or equal to 20 $\mu$m in thickness. In the second step, respective proportions of the raw material gases are: AlCl$_3$: 0.8 to 1.2% by volume, HCl: 0.5 to 4.0% by volume, CO$_2$: 3.5 to 4.0% by volume, CO: 1.0 to 5.5% by volume, H$_2$S: 0.5 to 0.7% by volume, and H$_2$: the balance in % by volume, based on the total of the raw material gases of 100% by volume. In the second step, the amount of $\Sigma$3 grain boundaries is increased and increase in size of the $\alpha$-Al$_2$O$_3$ particles is suppressed, by setting the film formation temperature to a high temperature of 1000°C, and controlling respective proportions of CO, HCl, CO$_2$, and H$_2$S to fall within the above ranges respectively.
In the transition from the first step to the second step, the total gas flow rate is gradually changed in 240 seconds from the time when the thickness of the $\alpha$-Al$_2$O$_3$ layer reaches 1.5 $\mu$m. Accordingly, $\Sigma$3 grain boundaries are easily formed continuously from the $\alpha$-Al$_2$O$_3$ layer formed in the first step to the $\alpha$-Al$_2$O$_3$ layer formed in the second step.

EXAMPLES

The present embodiment is described more specifically in connection with Examples. It should be noted that the present embodiment is not limited by these Examples.

<Preparation of Base Material>

A base material was prepared. Raw material powders (TaC powder: 2.0% by mass, NbC powder: 1.0% by mass, Co powder: 10.0% by mass, WC: the balance) for the base material were uniformly mixed, pressure-molded into a predetermined shape, and then sintered at 1300 to 1500°C for 1 to 2 hours to obtain a base material made of a cemented carbide (shape: model number: CNMG120408N-UX (manufactured by Sumitomo Electric Hardmetal Corp.)). "WC: the balance" indicates that the WC is the remainder in the composition (% by mass).

<Formation of Coating>

A coating was formed on a surface of the base material obtained as described above, to produce a cutting tool. Specifically, the base material was set in a CVD apparatus, and a coating was formed on the base material by CVD.

<<Formation of First Layer>>

For the specimens in Table 3 indicated with "TiCN" in the column "composition" of "First Layer", a TiCN layer was formed on the base material. The thickness of the first layer is the one as indicated in Table 3. Conditions for forming the TiCN layer are as follows.

Raw material gas composition: $TiCl_4$: 8.5% by volume, $CH_3CN$: 0.5% by volume, CO: 1.65% by volume, $N_2$: 10.0% by volume, HCl: 2.0% by volume, $H_2$: the balance in % by volume, based on the total of the raw material gases of 100% by volume
Raw material gas flow rate: 120 L/min
Pressure: 70 hPa
Temperature: 850°C

<<Formation of $\alpha$-$Al_2O_3$ Layer>>

Next, an $\alpha$-$Al_2O_3$ layer was formed directly on the first layer or directly on the base material. The step of forming the $\alpha$-$Al_2O_3$ layer includes a first step and a second step.
The first step is a step of forming a region, from the start of formation to formation of the $\alpha$-$Al_2O_3$ layer of 1.5 $\mu$m in thickness. The conditions for film formation (pressure, temperature, total gas flow rate) and the raw material gas composition in the first step are those as indicated in Table 1.
The second step is a step of forming a region of the $\alpha$-$Al_2O_3$ layer of more than 1.5 $\mu$m in thickness. The conditions for film formation (pressure, temperature, total gas flow rate) and the raw material gas composition in the second step are those as indicated in Table 2. When the thickness of the $\alpha$-$Al_2O_3$ layer formed in the second step reached the thickness indicated in the column "thickness" in Table 2, the second step was ended.
In Table 1, for the specimens indicated with "transition" in "Transition Step", the total gas flow rate was gradually changed in 240 seconds from the time when the thickness of the $\alpha$-$Al_2O_3$ layer reached 1.5 $\mu$m, in the transition from the first step to the second step. In Table 1, for the specimens indicated with "no transition" in "Transition Step", the gas flow rate was switched without particularly controlling the change of the gas flow rate.

<<Formation of Second Layer>>

Next, for the specimens in Table 3 indicated with "TiN, TiCN" in the column "composition" of "Second Layer", a TiN layer and a TiCN layer were formed in this order directly on the $\alpha$-$Al_2O_3$ layer. The thickness of each layer is the one as indicated in Table 3. Conditions for forming the TiN layer and the TiCN layer are as follows.

Conditions for Forming TiN Layer

Raw material gas composition: $TiCl_4$: 4.0% by volume, $N_2$: 42.5% by volume, $H_2$: the balance in % by volume, based on the total of the raw material gases of 100% by volume
Raw material gas flow rate: 80 L/min
Pressure: 70 hPa
Temperature: 1000°C

Conditions for Forming TiCN Layer

Raw material gas composition: $TiCl_4$: 8.5% by volume, $CH_3CN$: 0.5% by volume, CO: 1.65% by volume, $N_2$: 10.0% by volume, HCl: 2.0% by volume, $H_2$: the balance in % by volume, based on the total of the raw material gases of 100% by volume
Raw material gas flow rate: 120 L/min
Pressure: 90 hPa
Temperature: 1000°C

Through the above steps, a cutting tool of each specimen was obtained.

[Table 1]

Table 1

| Specimen No. | First Step | | | | | | | | | | Transition Step |
| | raw material gas composition (vol%) | | | | | | conditions for film formation | | | thickness | |
| | AlCl$_3$ | HCl | CO$_2$ | CO | H$_2$S | H$_2$ | pressure | temperature | total gas flow rate | μm | transition/ no transition |
| | | | | | | | hPa | C° | L/min | | |
|---|---|---|---|---|---|---|---|---|---|---|---|
| 1 | 1.5 | 2.0 | 1.5 | 2.5 | 0 | balance | 70 | 1000 | 80 | 1.5 | transition |
| 2 | 1.5 | 2.0 | 1.5 | 2.5 | 0 | balance | 70 | 1000 | 80 | 1.5 | transition |
| 3 | 1.5 | 2.0 | 1.5 | 2.5 | 0 | balance | 70 | 1000 | 80 | 1.5 | transition |
| 4 | 1.5 | 2.0 | 1.5 | 2.5 | 0 | balance | 70 | 1000 | 80 | 1.5 | transition |
| 5 | 1.5 | 2.0 | 1.5 | 2.5 | 0 | balance | 70 | 1000 | 80 | 1.5 | transition |
| 6 | 1.5 | 2.0 | 1.5 | 2.5 | 0 | balance | 70 | 1000 | 80 | 1.5 | transition |
| 7 | 1.5 | 2.0 | 1.5 | 2.5 | 0 | balance | 70 | 1000 | 80 | 1.5 | transition |
| 8 | 1.5 | 2.0 | 1.5 | 2.5 | 0 | balance | 70 | 1000 | 80 | 1.5 | transition |
| 9 | 1.5 | 2.0 | 1.5 | 2.5 | 0 | balance | 70 | 1000 | 80 | 1.5 | transition |
| 10 | 1.5 | 2.0 | 1.5 | 2.5 | 0 | balance | 70 | 1000 | 80 | 1.5 | transition |
| 11 | 1.5 | 2.0 | 1.5 | 2.5 | 0 | balance | 70 | 1000 | 80 | 1.5 | transition |
| 12 | 1.5 | 2.0 | 1.5 | 2.5 | 0 | balance | 70 | 1000 | 80 | 1.5 | transition |
| 1-1 | 2.5 | 2.5 | 2.0 | 1 | 0 | balance | 70 | 965 | 80 | 0.1 | no transition |
| 1-2 | 2.5 | 1.5 | 3.0 | 0.0 | 0.1 | balance | 70 | 950 | 80 | 1.0 | no transition |
| 1-3 | 1.5 | 2.0 | 1.5 | 2.5 | 0 | balance | 70 | 1000 | 80 | 1.5 | transition |

[Table 2]

Table 2

| Spedmen No. | Second Step | | | | | | | | | |
| | raw material gas composition (vol%) | | | | | | conditions for film formation | | | thickness |
| | AlCl$_3$ | HCl | CO$_2$ | CO | H$_2$S | H$_2$ | pressure | temperature | total gas flow rate | μm |
| | | | | | | | hPa | C° | L/min | |
|---|---|---|---|---|---|---|---|---|---|---|
| 1 | 1.0 | 2.0 | 4.0 | 2.5 | 0.6 | balance | 70 | 1000 | 120 | 6.5 |
| 2 | 1.0 | 2.0 | 4.0 | 1.0 | 0.6 | balance | 70 | 1000 | 120 | 6.5 |
| 3 | 1.0 | 4.0 | 4.0 | 5.0 | 0.6 | balance | 70 | 1000 | 120 | 6.5 |

(continued)

| Spedmen No. | Second Step | | | | | | | | | thickness |
| | raw material gas composition (vol%) | | | | | | conditions for film formation | | | |
| | AlCl₃ | HCl | CO₂ | CO | H₂S | H₂ | pressure | temperature | total gas flow rate | μm |
| | | | | | | | hPa | C° | L/min | |
| 4 | 1.0 | 1.0 | 4.0 | 2.5 | 0.6 | balance | 70 | 1000 | 120 | 6.5 |
| 5 | 1.0 | 0.5 | 4.0 | 2.5 | 0.6 | balance | 70 | 1000 | 120 | 6.5 |
| 6 | 1.0 | 2.0 | 4.0 | 2.5 | 0.6 | balance | 70 | 1000 | 120 | 6.5 |
| 7 | 1.0 | 2.0 | 4.0 | 2.5 | 0.6 | balance | 70 | 1000 | 120 | 1.5 |
| 8 | 1.0 | 2.0 | 4.0 | 2.5 | 0.6 | balance | 70 | 1000 | 120 | 1.3 |
| 9 | 1.0 | 2.0 | 4.0 | 2.5 | 0.6 | balance | 70 | 1000 | 120 | 18.5 |
| 10 | 1.0 | 2.0 | 4.0 | 2.5 | 0.6 | balance | 70 | 1000 | 120 | 19.5 |
| 11 | 1.0 | 2.0 | 4.0 | 2.5 | 0.6 | balance | 70 | 1000 | 120 | 6.5 |
| 12 | 1.0 | 4.0 | 4.0 | 5.5 | 0.6 | balance | 70 | 1000 | 120 | 6.5 |
| 1-1 | 3.0 | 2.5 | 3.3 | 0 | 0.2 | balance | 70 | 980 | 80 | 8.0 |
| 1-2 | 2.0 | 5.0 | 7.5 | 0 | 0.8 | balance | 70 | 950 | 80 | 7.0 |
| 1-3 | 1.0 | 2.0 | 4.0 | 0.5 | 0.6 | balance | 70 | 1000 | 120 | 6.5 |

[Table 3]

Table 3

| Specimen No. | α-Al$_2$O$_3$ layer | | | | First Layer | | Second Layer | | Cutting Test |
| --- | --- | --- | --- | --- | --- | --- | --- | --- | --- |
| | number of first Σ3 grain boundaries | number of all grain boundaries | orientation index TC(0012) | thickness μm | composition | thickness μm | composition | thickness μm | tool life min |
| 1 | 10 | 60 | 7 | 8.0 | TiCN | 8 | TiN,TiCN | 2 | 25 |
| 2 | 5 | 60 | 7 | 8.0 | TiCN | 8 | TiN,TiCN | 2 | 17 |
| 3 | 100 | 120 | 7 | 8.0 | TiCN | 8 | TiN,TiCN | 2 | 17 |
| 4 | 10 | 20 | 5 | 8.0 | TiCN | 8 | TiN,TiCN | 2 | 22 |
| 5 | 10 | 15 | 5 | 8.0 | TiCN | 8 | TiN,TiCN | 2 | 15 |
| 6 | 10 | 60 | 5 | 8.0 | TiCN | 8 | TiN,TiCN | 2 | 17 |
| 7 | 10 | 60 | 4.5 | 3.0 | TiCN | 8 | TiN,TiCN | 2 | 15 |
| 8 | 10 | 60 | 7 | 2.8 | TiCN | 8 | TiN,TiCN | 2 | 15 |
| 9 | 10 | 60 | 7 | 20.0 | TiCN | 8 | TiN,TiCN | 2 | 30 |
| 10 | 10 | 60 | 7 | 21.0 | TiCN | 8 | TiN,TiCN | 2 | 16 |
| 11 | 10 | 60 | 7 | 12.0 | - | 0 | - | 0 | 17 |
| 12 | 110 | 120 | 7 | 8.0 | TiCN | 8 | TiN,TiCN | 2 | 15 |
| 1-1 | 3 | 30 | 7 | 8.0 | TiCN | 8 | TiN,TiCN | 2 | 10 |
| 1-2 | 3 | 30 | 6 | 8.0 | TiCN | 8 | TiN,TiCN | 2 | 10 |
| 1-3 | 3 | 40 | 7 | 8.0 | TiCN | 8 | TiN,TiCN | 2 | 13 |

[Evaluation]

<Number of First $\Sigma 3$ Grain Boundaries>

In the $\alpha$-Al$_2$O$_3$ layer of the cutting tool of each specimen, the number of first $\Sigma 3$ grain boundaries in the measurement field as described in connection with Embodiment 1 was measured. It was measured specifically by the method described in connection with Embodiment 1. The results are shown in the column "number of first $\Sigma 3$ grain boundaries" in Table 3.

<Number of All Grain Boundaries Intersecting Imaginary Line L3>

In the $\alpha$-Al$_2$O$_3$ layer of the cutting tool of each specimen, the number of all grain boundaries intersecting imaginary line L3 in the measurement field as described in connection with Embodiment 1 was measured. It was measured specifically by the method as described in connection with Embodiment 1. The results are shown in the column "number of all brain boundaries" in Table 3.

<Orientation Index TC(0 0 12)>

For the $\alpha$-Al$_2$O$_3$ layer of the cutting tool of each specimen, the orientation index TC(0 0 12) was measured. It was measured specifically by the method as described in connection with Embodiment 1. The results are shown in Table 3.

<Cutting Test>

A cutting test was performed under the conditions, using the cutting tool of each specimen. The area (mm$^2$) of the base material exposed on the rake face was measured every one minute of the cutting time. The time when the exposed area exceeded 0.2 mm$^2$ was defined as tool life. The results are shown in Table 3. The longer the tool life, the better the crater wear resistance of the cutting tool.

<<Cutting Conditions>>

Workpiece: SCM415
Machining: turning of the outer diameter of a round bar
Cutting speed: 500 m/min
Feed rate: 0.2 mm/rev
Cutting depth: 2.0 mm
Cutting fluid: water-soluble cutting oil

<Discussions>

The cutting tools of Specimens 1 to 12 correspond to Examples. The cutting tools of Specimen 1-1 to Specimen 1-3 correspond to Comparative Examples. It was confirmed that the cutting tools of Specimens 1 to 12 had a longer tool life than the cutting tools of Specimens 1-1 to 1-3.

In the $\alpha$-Al$_2$O$_3$ layer of Specimen 1-1, the ratio of $\Sigma 3$ grain boundaries was high in a lower portion close to the base material, while the ratio of $\Sigma 3$ grain boundaries was low in an upper portion of the $\alpha$-Al$_2$O$_3$ layer and the number of first $\Sigma 3$ grain boundaries was small in the upper portion. Therefore, $\alpha$-Al$_2$O$_3$ particles were lost from the upper portion and crater wear easily occurred.

In the $\alpha$-Al$_2$O$_3$ layer of Specimen 1-2, the $\Sigma 3$ grain boundary in the region formed in the first step and the $\Sigma 3$ grain boundary in the region formed in the second step were not continuous, and the number of first $\Sigma 3$ grain boundaries was small. Therefore, as cracks grow in the Al$_2$O$_3$ layer, $\alpha$-Al$_2$O$_3$ particles were lost and crater wear easily occurred.

In the $\alpha$-Al$_2$O$_3$ layer of Specimen 1-3, the ratio of $\Sigma 3$ grain boundaries was low in the entire region, and the number of first $\Sigma 3$ grain boundaries was small. Therefore, as cracks grow in the $\alpha$-Al$_2$O$_3$ layer, $\alpha$-Al$_2$O$_3$ particles were lost and crater wear easily occurred.

Although the embodiments and Examples of the present disclosure have been described above, the configurations of the above-described embodiments and Examples are contemplated from the beginning to be appropriately combined or variously modified. The embodiments and Examples disclosed herein should be considered as exemplary and not as restrictive in all respects. It is intended that the scope of the present invention is defined by claims, not by the embodiments and Examples described above, and encompasses all modifications equivalent in meaning and scope to the claims.

REFERENCE SIGNS LIST

10 base material; 10a main surface; 11 $\alpha$-Al$_2$O$_3$ layer; 12 first layer; 13 second layer; 15 coating; S1 first interface; S2 second interface; R1 measurement field; a1, a2, a3, a4, a5, a6, a7 $\Sigma$3 grain boundary.

**Claims**

1. A cutting tool comprising a base material and a coating provided on the base material, wherein

   the coating comprises an $\alpha$-Al$_2$O$_3$ layer,
   the $\alpha$-Al$_2$O$_3$ layer has a thickness of 3 $\mu$m or more and 20 $\mu$m or less, and
   in a measurement field in a rectangular shape that is provided in a cross section of the coating along a normal line to a surface of the coating, and has a dimension of 30 $\mu$m in a first direction along the surface of the coating, and a dimension in a second direction orthogonal to the first direction of the coating, including an entire thickness of the $\alpha$-Al$_2$O$_3$ layer along the second direction,
   the number of first $\Sigma$3 grain boundaries continuous from an imaginary line L1 to an imaginary line L2 and intersecting an imaginary line L3 is 5 or more, wherein

      the imaginary line L1 is an imaginary line at a distance of 0.5 $\mu$m toward the $\alpha$-Al$_2$O$_3$ layer, from a first interface of the $\alpha$-Al$_2$O$_3$ layer, the first interface being an interface located toward the base material,
      the imaginary line L2 is an imaginary line at a distance of 0.5 $\mu$m toward the $\alpha$-Al$_2$O$_3$ layer, from a second interface of the $\alpha$-Al$_2$O$_3$ layer, the second interface being an interface located toward the surface of the coating, and
      the imaginary line L3 is an imaginary line located equidistantly from the imaginary line L1 and the imaginary line L2.

2. The cutting tool according to claim 1, wherein the number of the first $\Sigma$3 grain boundaries is 100 or less.

3. The cutting tool according to claim 1 or 2, wherein in the measurement field, the number of all grain boundaries intersecting the imaginary line L3 is 20 or more.

4. The cutting tool according to any one of claims 1 to 3, wherein the $\alpha$-Al$_2$O$_3$ layer has a TC(0 0 12) of 5 or more in an orientation index TC(hkl).

5. The cutting tool according to any one of claims 1 to 4, wherein

   the coating further comprises a first layer disposed between the base material and the $\alpha$-Al$_2$O$_3$ layer, and
   the first layer is a TiCN layer.

6. The cutting tool according to any one of claims 1 to 5, wherein

   the coating further comprises a second layer disposed on a main surface of the $\alpha$-Al$_2$O$_3$ layer opposite to a main surface of the $\alpha$-Al$_2$O$_3$ layer located relatively closer to the base material, and
   the second layer comprises at least one selected from the group consisting of TiN layer, TiCN layer, and TiCNO layer.

FIG.1

FIRST DIRECTION

SECOND
DIRECTION

0.5μm

30μm

0.5μm

P1

1

13
S2

L2

R1

L3

L1

S1

12

10

11

15

FIG.2

FIG.3

# INTERNATIONAL SEARCH REPORT

| International application No. |
| --- |
| **PCT/JP2024/019734** |

## A. CLASSIFICATION OF SUBJECT MATTER

*B23B 27/14*(2006.01)i; *C23C 16/40*(2006.01)i
FI:   B23B27/14 A; C23C16/40

According to International Patent Classification (IPC) or to both national classification and IPC

## B. FIELDS SEARCHED

Minimum documentation searched (classification system followed by classification symbols)

B23B27/14; B23B51/00; B23C5/00; B23P15/28; C23C16/40

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| X | WO 2014/132995 A1 (MITSUBISHI MATERIALS CORPORATION) 04 September 2014 (2014-09-04) | 1-3 |
|   | paragraphs [0013]-[0025], table 9, fig. 3B, 4 | |
| Y | | 4-5 |
| A | | 6 |
| Y | JP 2022-131058 A (TUNGALOY CORPORATION) 07 September 2022 (2022-09-07) | 4-5 |
|   | paragraphs [0017], [0033]-[0049] | |
| A | JP 2009-184046 A (MITSUBISHI MATERIALS CORPORATION) 20 August 2009 (2009-08-20) | 1-6 |
| A | JP 2023-101044 A (MITSUBISHI MATERIALS CORPORATION) 20 July 2023 (2023-07-20) | 1-6 |
| A | JP 2020-506811 A (WALTER AG) 05 March 2020 (2020-03-05) | 1-6 |
| A | US 2013/0156517 A1 (SECO TOOLS AB) 20 June 2013 (2013-06-20) | 1-6 |

☐ Further documents are listed in the continuation of Box C.　　☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **16 July 2024** | **30 July 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

### INTERNATIONAL SEARCH REPORT
**Information on patent family members**

International application No.

**PCT/JP2024/019734**

| Patent document cited in search report | | | Publication date (day/month/year) | Patent family member(s) | | | Publication date (day/month/year) |
|---|---|---|---|---|---|---|---|
| WO | 2014/132995 | A1 | 04 September 2014 | US | 2016/0001375 | A1 | |
| | | | | paragraphs [0052]-[0110], table 9, fig. 3B, 4 | | | |
| | | | | JP | 2014-193523 | A | |
| | | | | EP | 2962794 | A1 | |
| | | | | CN | 105026082 | A | |
| | | | | KR | 10-2015-0120373 | A | |
| JP | 2022-131058 | A | 07 September 2022 | US | 2022/0274892 | A1 | |
| | | | | paragraphs [0038], [0054]-[0072] | | | |
| | | | | EP | 4050124 | A1 | |
| | | | | CN | 114951823 | A | |
| JP | 2009-184046 | A | 20 August 2009 | (Family: none) | | | |
| JP | 2023-101044 | A | 20 July 2023 | (Family: none) | | | |
| JP | 2020-506811 | A | 05 March 2020 | US | 2020/0002819 | A1 | |
| | | | | WO | 2018/138255 | A1 | |
| | | | | CN | 110100046 | A | |
| | | | | KR | 10-2019-0103223 | A | |
| US | 2013/0156517 | A1 | 20 June 2013 | WO | 2011/154392 | A1 | |
| | | | | EP | 2395126 | A1 | |
| | | | | CN | 102933742 | A | |
| | | | | KR | 10-2013-0115089 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002131058 A

- JP 2023101044 A

**Non-patent literature cited in the description**

- **H. GRIMMER ; R. BONNET**. *Philosophical Magazine A*, 1990, vol. 61, 493-509

- **D. BRANDON**. *Acta metall.*, 1966, vol. 14, 1479-1484